# EUROPÄISCHE PATENTANMELDUNG

(11) **EP 3 715 500 A1**
(43) Veröffentlichungstag der Anmeldung: **30.09.2020**
(21) Anmeldenummer: 20164859.9
(22) Anmeldetag: 23.03.2020
(51) Int. Cl.: C23C 16/04, B65D 1/02, B65D 65/42, B65D 23/02

(54) **VERFAHREN UND VORRICHTUNG ZUM BESCHICHTEN VON BEHÄLTNISSEN**

(30) Priorität: 26.03.2019 DE 102019107660
(71) Anmelder: Krones AG, 93073 Neutraubling (DE)
(72) Erfinder: Fischer, Sven, 93073 Neutraubling (DE)
(74) Vertreter: Bittner, Bernhard

(57) **Zusammenfassung**

Verfahren zum Beschichten von Behältnissen (10), und insbesondere Getränkebehältnissen, welche dazu geeignet und bestimmt sind eine Flüssigkeit aufzunehmen, wobei das zu beschichtende Behältnis (10) einen Grundkörper (10d), einen Schulterbereich (10b), einen Bodenbereich (10c) und einen Mündungsbereich (10a) aufweist, wobei zum Beschichten einer Innenwandung (14) und/oder einer Außenwandung (12) des Behältnisses (10) aus einem fließfähigen Precursor ein siliziumhaltiges Beschichtungsmaterial erzeugt wird, welches auf die Innenwandung (14) und/oder die Außenwandung (12) des Behältnisses (10) aufgebracht wird. Erfindungsgemäß handelt es sich bei dem zu beschichtenden Behältnis (10) um ein Behältnis aus einem faserbasierten Material.

## Beschreibung

Die vorliegende Erfindung bezieht sich auf ein Verfahren und eine Vorrichtung zur Beschichtung einer Innenwandung und/oder einer Außenwandung von Behältnissen und auf ein Behältnis zur Aufnahme einer Flüssigkeit. Derartige Verfahren und Vorrichtungen zum Beschichten von Behältnissen sind aus dem Stand der Technik seit langem bekannt. Dabei werden vor allem die Innenwandungen und die Außenwandungen von Getränkeflaschen aus Kunststoff oder Glas beschichtet, um die Barriere gegen Aus- und Eintreten von Gasen, Licht oder dergleichen zu verbessern sowie auch die Feuchtigkeitsresistenz dieser Behältnisse zu verbessern. Auf diese Weise kann insbesondere auch ein Diffundieren von Flüssigkeit oder Gas aus dem Inneren des Behältnisses nach außen verhindert werden.

Vor allem im Milch- und Saftbereich ist man dazu übergegangen, in Kartonverpackungen abzufüllen. Vorteil dieser Kartonverpackungen, im Gegensatz zu den üblichen transparenten Kunststoff- oder Glasverpackungen, sind hier die guten Barriereeigenschaften gegen Licht, Sauerstoff, andere Gase und Aromen. Ein Nachteil dieser Kartonverpackungen ist jedoch die fehlende freie Formbarkeit der Behälter zur Differenzierung und demnach der Wiedererkennungswert aufgrund einer originellen oder einzigartigen Behälterform.

Es wird daher seit längerer Zeit nach Möglichkeiten gesucht frei formbare faserbasierte Behälter für flüssige Lebensmittel zu entwickeln. Dabei wird insbesondere auch die Vermeidung von Kunststoffmaterialien aufgrund von Mikroplastik und Plastik in Meeren, in der Nahrungsmittelkette bzw. -industrie immer wichtiger. Die Kartonhersteller suchen deshalb nach Alternativen zu den gängigen Kunststoffen und nach Möglichkeiten, um frei formbare faserbasierte Behälter, sogenannte Pulpeflaschen, ohne die Verwendung von Kunststoffen, von innen und von außen flüssigkeitsdicht, gasdicht, aromadicht und feuchtigkeitsdicht zu bekommen. Beispielswiese oxidiert durch das Eindringen von Sauerstoff von außen in die Flasche das Produkt. Somit wird die Haltbarkeit des Getränks reduziert.

Aus dem internen Stand der Technik der Anmelderin wurden die Behältnisse daher vor einiger Zeit mit Wachs beschichtet, was allerdings erhebliche Nachteile hat. Derzeit wird daher beispielsweise LDPE flüssig auf die zu beschichtenden Behältnisse aufgesprüht oder als Pulver aufgebracht und verschmolzen. Der Nachteil hierbei ist jedoch, dass es sich hierbei wiederum um eine Kunststoffschicht mit den entsprechenden Nachteilen in der Wahrnehmung, beim Recycling etc. handelt.

Der vorliegenden Erfindung liegt daher die Aufgabe zugrunde, ein Beschichtungsverfahren sowie eine Vorrichtung für ein faserbasiertes Behältnis bereitzustellen, welches/welche es ermöglichen ein flüssigkeits-, gas-, aroma-, und feuchtigkeitsdichtes Behältnis bereitzustellen. Diese Aufgabe wird erfindungsgemäß durch die Gegenstände der unabhängigen Ansprüche erreicht. Vorteilhafte Ausführungsformen und Weiterbildungen sind Gegenstand der Unteransprüche.

Die Erfindung ist daher auf ein Verfahren zum Beschichten von Behältnissen, und insbesondere Getränkebehältnissen, gerichtet, welche dazu geeignet und bestimmt sind eine Flüssigkeit aufzunehmen, wobei das zu beschichtende Behältnis einen Grundkörper, einen Schulterbereich, einen Bodenbereich und einen Mündungsbereich aufweist, wobei zum Beschichten einer Innenwandung und/oder einer Außenwandung des Behältnisses aus einem fließfähigen Precursor ein siliziumhaltiges Beschichtungsmaterial erzeugt wird, welches auf die Innenwandung und/oder die Außenwandung des Behältnisses aufgebracht wird.

Erfindungsgemäß handelt es sich bei dem zu beschichtenden Behältnis um ein Behältnis aus einem faserbasierten Material. Bei dem fließfähigen Precursor handelt es sich besonders bevorzugt um ein siliziumhaltiges Gas.

Dabei ist es bevorzugt auch möglich, dass neben den Fasern auch noch andere Bestandteile in dem Material vorhanden sind, wie beispielsweise auch Kunststoffmaterialien oder Kunststofffasern.

Der mit der Erfindung hergestellte Behälter kann demnach durch die Beschichtung mit einem siliziumhaltigen Beschichtungsmaterial für Flüssigkeiten verwendet werden und ist, aufgrund der Vermeidung von Kunststoffen zur Beschichtung und zur Herstellung des Behältnisses selbst, besonders umweltfreundlich. Ein derartiger Behälter zerfällt idealerweise nach längerer Verweildauer z.B. im Meer vollständig in seine Bestandteile. Durch die Beschichtung wird demnach eine Schicht auf die Wandungen des Behältnisses aufgebracht, welche nahezu undurchlässig für Flüssigkeiten und Gase ist und zudem vollkommen auf Kunststoffanteile verzichtet.

Bei einem bevorzugten Verfahren ist das Behältnis während der Beschichtung in einer Beschichtungskammer angeordnet. Diese Beschichtungskammer ist dabei mittels einer Vielzahl von Wänden und insbesondere mittels zwei Seitenwänden, einer Deckenwandung und einer Bodenwandung gegenüber der Umgebung abgegrenzt.

Dabei ist besonders bevorzugt eine Transporteinrichtung vorgesehen, welche die Behältnisse nach der Herstellung zu der Beschichtungskammer transportiert. Bevorzugt werden die Behältnisse während des Transports innerhalb der Beschichtungskammer beschichtet.

Vorteilhaft weist das Beschichtungsmaterial keinerlei Kunststoffmaterialien oder Kunststoffanteile auf. Das verwendete Beschichtungsmaterial ist demnach vollständig kunststofffrei und kann gemeinsam mit dem faserbasierten Behältnis entsorgt bzw. recycelt werden. Durch diese kunststoffarme Beschichtung ist es demnach nicht erforderlich, die inneren Bestandteile des Behältnisses von der Außenwandung zu trennen und getrennt von dem Behältnis zu entsorgen, wie dies beispielsweise bei bekannten faserbasierten Behältnissen der Fall ist. Bei diesen bekannten Behältnissen wurde beispielsweise ein Kunststoffvorformling innerhalb eines faserbasierten Behältnisses expandiert oder ein Barriere-Beutel aus Kunststoff in das faserbasierte Behältnis eingesetzt, um die Dichtheit dieses Behältnisses zu gewährleisten. Diese müssen allerdings getrennt von dem faserbasierten Behältnis entsorgt und recycelt werden.

Bei einem bevorzugten Verfahren ist das faserbasierte Material aus einer Gruppe von Materialien ausgewählt ist, welche Pulpe-Material (Pappmaschee), Zellstoff, Papiermasse oder dergleichen enthält.

Besonders voreilhaft handelt es sich bei dem siliziumhaltigen Beschichtungsmaterial um Si-Ox. Durch die Beschichtung mi SiOx wird eine dünne Glas- bzw. glasartige Schicht im nm Bereich auf der Innenwandung und/oder der Außenwandung des Behältnisses gebildet. Das "x" in der SiOx Verbindung kann dabei den Wert 2, 3 oder 4 annehmen, so dass die Verbindung SiO₂, SiO₃ oder SiO₄ gebildet wird.

In einem besonders bevorzugten Verfahren wird zur Beschichtung der Innenwandung des Behältnisses der fließfähige Precursor verdampft und zusammen mit einem gasförmigen Medium und insbesondere mit einem sauerstoffhaltigen Gas in das Innere des Behältnisses eingeleitet. Wie oben bereits erwähnt handelt es sich bei dem fließfähigen Precursor besonders bevorzugt um ein siliziumhaltiges Gas.

Zur Beschichtung der Innenwandung wird dabei bevorzugt Energie in Form von elektromagnetischer Strahlung, wie Mikrowellen, Hochfrequenz oder Niederfrequenz, zugeführt. Besonders bevorzugt wird diese Strahlung in die oben erwähnte Beschichtungskammer eingeleitet. Die Strahlung gelangt anschließend durch die Wandung des Behältnisses in den Innenraum des Behältnisses und erzeugt in Verbindung mit dem in das Behältnis eingeleiteten Gas (siliziumhaltiges Gas + Sauerstoff) ein Plasma innerhalb des Behältnisses. Durch diese Energiezufuhr und die Entstehung des Plasmas werden die Gasmoleküle des siliziumhaltigen Gases in ihre Bestandteile zerlegt bzw. spalten sich auf, wodurch sich das eigentliche Beschichtungsmaterial SiOx bildet, welches sich anschließend auf die Innenwandung des Behältnisses ablegt. Diese chemische Gasphasenabscheidung bzw. Plasmapolymerisation ist dabei insbesondere zur Beschichtung von temperaturempfindlichen Materialien vorteilhaft, da eine geringe Temperaturbelastung vorliegt.

Alternativ wäre es allerdings auch möglich, dass neben dem Gas eine Elektrode in das Behältnis eingeführt wird, welche mit Spannungsimpulsen beaufschlagt wird, woraus sich wiederum das Plasma bildet und durch die Zerlegung bzw. die Aufspaltung der Gasmoleküle des eingeführten Gases das SiOx auf der Innenwandung des Behältnisses abgeschieden wird.

Bei der Bildung des SiOx werden darüber hinaus CO₂ und H₂O gebildet, welche als "Abgase" abgeführt werden. Eine mögliche Reaktionsgleichung des obigen Vorgangs lautet dabei beispielsweise:

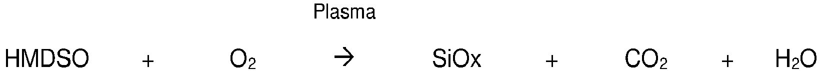

Bei dem HMDSO handelt es sich dabei um den fließfähigen Precursor bzw. das siliziumhaltige Gas, welches gemeinsam mit Sauerstoff dem Behältnis zugeführt wird. Bei der entstehenden Verbindung SiOx handelt es sich um das Beschichtungsmaterial und bei dem CO₂ und dem H₂O um die oben erwähnten "Abgase". Das HMDSO wird dabei in dieser Reaktion beispielshaft für das siliziumhaltige Gas verwendet. Denkbar wären dabei allerdings auch andere fließfähige Medien. Der fließfähige Precursor ist demnach bei einer bevorzugten Ausführungsform aus einer Gruppe von Precursoren ausgewählt, welche HMDSO, HMDSN, TEOS oder andere Si-haltige Verbindungen und dergleichen enthält.

Bei beiden beschriebenen Beschichtungsmethoden wird dabei bevorzugt innerhalb des Behältnisses ein Vakuum erzeugt. Hierzu wird der Mündungsbereich des Behältnisses dichtend an eine Dichtungseinrichtung angelegt. Diese Dichtungseinrichtung befindet sich besonders bevorzugt ebenfalls innerhalb der Beschichtungskammer. Bei dem oben beschriebenen Verfahren handelt es sich besonders bevorzugt um ein Plasmabeschichtungsverfahren (PECVD = plasma-enhanced chemical vapor deposition). Der Gaseinlass und die Mikrowellenzufuhr kann dabei vorteilhaft auch über eine gemeinsame Zuführleitung erfolgen, welche in das Behältnis eingeführt wird.

Bei einem weiteren bevorzugten Verfahren wird zur Beschichtung der Außenwandung des Behältnisses der fließfähige Precursor unter thermischer Einwirkung auf die Außenwandung des Behältnisses aufgebracht.

Der fließfähige Precursor bzw. das siliziumhaltige Gas wird dabei innerhalb oder außerhalb eines Spritzbrenners zu SiOx umgewandelt und mittels eines Gasstroms in Form von Spritzpartikeln auf die Außenoberfläche bzw. Außenwandung des Behältnisses geschleudert. Alternativ hierzu kann das Behältnis auch erhitzt werden und der fließfähigen Precursor in die Beschichtungskammer eingebracht werden. Durch das erhitzte Behältnis erfolgt eine thermische Aktivierung des Precursors und hieraus die Bildung von SiOx, welches sich wiederum auf der Behältniswandung abscheidet.

Mit der vorliegenden Erfindung wird demnach ein Beschichtungsverfahren bzw. eine Anlage zum Plasmabeschichten von PET und/oder Glasflaschen auf faserbasierte Behältnisse bzw. sogenannte Pulpeflaschen übertragen. Durch die Innenbeschichtung mit SiOx im Vakuum wird dabei die Barriere zu verbessert. Um Glasflaschen für das Bedrucken mit Tinte vorzubereiten wird üblicherweise mit einer Flamme eine SiOx Schicht aufgetragen, um die Oberflächenenergie der Oberfläche zu erhöhen und die Bedruckung zu verbessern. Dieses Vorgehen wird dabei für eine Außenbeschichtung zur Verbesserung der Feuchtigkeitsresistenz verwendet und wird mit der vorliegenden Erfindung ebenfalls für die Beschichtung von Pulpeflaschen angewandt.

Bei einem bevorzugten Verfahren wird die Beschichtung der Innenwandung und der Außenwandung des Behältnisses wenigstens zeitweise gleichzeitig durchgeführt. Denkbar wäre dabei allerdings auch, dass die Beschichtung der Innenwandung und der Außenwandung des Behältnisses bevorzugt nacheinander durchgeführt wird und besonders bevorzugt direkt aufeinanderfolgend.

Bei einem weiteren bevorzugten Verfahren ist zumindest der Grundkörper, der Schulterbereich und der Bodenbereich des Behältnisses aus einem faserbasierten Material hergestellt. Vorteilhaft ist dabei wenigstens der Mündungsbereich des Behältnisses aus einem Kunststoffmaterial, wie PET, PP, PS, PE oder dergleichen hergestellt. Unter dem Mündungsbereich wird dabei die Öffnung, das Gewinde und der Tragring des Behältnisses verstanden. Der aus dem Kunststoffmaterial hergestellte Mündungsbereich des Behältnisses kann dabei besonders bevorzugt getrennt von dem Grundkörper, dem Schulterbereich und dem Bodenbereich des Behältnisses recycelt werden. Das zu beschichtende Behältnis weist demnach vorteilhaft, im Vergleich zu herkömmlichen PET-Flaschen oder auch zu bereits bekannten Kartonverpackungen für Getränke, einen sehr geringen Kunststoffanteil auf.

Vorteilhaft weist das Behältnis weiterhin einen Verschluss auf, wobei der Verschluss aus einem Kunststoffmaterial wie PET, PP, PS, PE oder dergleichen oder einem Metall, wie Aluminium oder dergleichen hergestellt ist. Bevorzugt ist demnach auch der Verschluss des Behältnisses getrennt von dem Grundkörper, dem Schulterbereich und dem Bodenbereich des Behältnisses recyclebar.

Die vorliegende Erfindung ist weiterhin auch auf eine Vorrichtung zum Beschichten von Behältnissen, und insbesondere Getränkebehältnissen, gerichtet, welche dazu geeignet und bestimmt sind eine Flüssigkeit aufzunehmen, wobei das zu beschichtende Behältnis einen Grundkörper, einen Schulterbereich, einen Bodenbereich und einen Mündungsbereich aufweist, und die Vorrichtung eine Vielzahl von Beschichtungsstationen aufweist, wobei die Behältnisse mittels einer Transporteinrichtung zu den Beschichtungsstationen transportierbar sind, wobei innerhalb der Beschichtungsstation ein siliziumhaltiges Beschichtungsmaterial auf die Innenwandung und/oder die Außenwandung des Behältnisses aufbringbar ist.

Erfindungsgemäß handelt es sich dabei bei dem zu beschichtenden Behältnis um ein Behältnis aus einem faserbasierten Material.

Vorteilhaft handelt es sich bei der Beschichtungsstation um einen geschlossenen Raum, wobei dieser geschlossene Raum bevorzugt die oben erwähnte Beschichtungskammer ausbildet. Besonders bevorzugt ist die Vielzahl von Beschichtungsstationen an einem beweglichen und insbesondere drehbaren Träger angeordnet.

Die Vorrichtung zum Beschichten der Behältnisse ist dabei bevorzugt einer Vorrichtung zum Herstellen der Behältnisse und besonders bevorzugt einer Vorrichtung zum Herstellen der faserbasierten Behältnisse vorgeschaltet. Die Behältnisse werden dabei bevorzugt mit der Transporteinrichtung von der Vorrichtung zum Herstellen der Behältnisse zu der Vorrichtung zum Beschichten der Behältnisse transportiert. Die Beschichtung der Behältnisse wird dabei bevorzugt während des Transports der Behältnisse durch die Vorrichtung durchgeführt. Die Beschichtungsstationen bewegen sich hierzu bevorzugt mit den Behältnissen mit. Denkbar wäre allerdings auch, dass es sich bei den Beschichtungsstationen um stationäre Beschichtungsstationen handelt und die Behältnisse demnach während der Beschichtung nicht bewegt werden und insbesondere nicht durch die Vorrichtung transportiert werden.

Die Transporteinrichtung weist dabei vorteilhaft eine Vielzahl von Halteeinrichtungen auf. Bei diesen Halteeinrichtungen handelt es sich bevorzugt um Greifer, welche die Behältnisse an ihrem Mündungsbereich und demnach an ihren "Kunststoffteilen" greifen. Denkbar wäre allerdings auch, dass es ich bei den Halteeinrichtungen um Dorne handelt, welche in die Mündungen der Behältnisse eingeführt werden.

Bevorzugt handelt es sich bei der Vorrichtung zum Beschichten der Behältnisse um eine Plasmabeschichtungsanlage.

Bei einer weiteren vorteilhaften Ausführungsform weist die Vorrichtung eine Zuführleitung auf, welche dazu geeignet und bestimmt ist, dem Behältnis ein fließfähiges und insbesondere gasförmiges Medium zuzuführen und insbesondere ein fließfähiges Medium in das Behältnis einzuführen. Insbesondere handelt es sich dabei um ein gasförmiges Medium, welches letztlich zur Beschichtung der Innenwandungen des Behältnisses dient und vorteilhaft um den oben erwähnten Precursor und ein weiteres Gas, wie bevorzugt Sauerstoff.

Vorteilhaft weist die Vorrichtung weiterhin eine zweite Zuführleitung auf, welche dazu geeignet und bestimmt ist, der Beschichtungskammer bzw. der Beschichtungsstation ein fließfähiges und insbesondere gasförmiges Medium zuzuführen. Hierbei handelt es sich entsprechend um ein gasförmiges Medium, welches zur Beschichtung der Außenwandungen des Behältnisses dient und demnach vorteilhaft wiederum um den oben erwähnten Precursor und ein weiteres Gas, wie bevorzugt Sauerstoff.

Die vorliegende Erfindung ist weiterhin auch auf ein Behältnis zur Aufnahme einer Flüssigkeit, wie insbesondere einem Getränk, gerichtet, wobei das Behältnis entlang seiner Längsrichtung aufeinanderfolgend einen Mündungsbereich, einen Schulterbereich, einen Grundkörper und einen Bodenbereich aufweist, wobei zumindest der Grundkörper und der Bodenbereich des Behältnisses aus einem faserbasierten Material hergestellt ist.

Erfindungsgemäß weist das Behältnis an einer Innenwandung und/oder einer Außenwandung eine Beschichtung aus einem siliziumhaltigen Beschichtungsmaterial auf. Das erfindungsgemäße Behältnis wird demnach mit einem kunststofffreien Beschichtungsmaterial beschichtet.

Der Grundkörper und der Bodenbereich des Behältnisses sind demnach bevorzugt getrennt von dem Schulterbereich und dem Mündungsbereich recyclebar. Der Schulterbereich und der Mündungsbereich sind dabei bevorzugt aus bekannten Kunststoffmaterialien, wie PET, PP, PS, PE oder dergleichen hergestellt, wie die bereits aus dem Stand der Technik bekannten Getränkeflaschen.

Das Behältnis ist dabei bevorzugt derart ausgebildet, dass es zur Aufnahme von Flüssigkeiten, wie insbesondere Milch, Saft, karbonisierten und nicht karbonisierten Softdrinks, Bier, Wasser, Wein, Sekt, Spirituosen, Liquid Food und dergleichen geeignet und bestimmt ist. Das Behältnis ist bevorzugt ferner dazu geeignet und bestimmt mit dem oben beschriebenen Beschichtungsverfahren beschichtet zu werden bzw. mit der oben beschriebenen Vorrichtung behandelt zu werden.

Unter einer aufeinanderfolgenden Anordnung des Mündungsbereichs, des Schulterbereichs, des Grundkörpers und des Bodenbereichs wird dabei verstanden, dass das Behältnis in einer aufrechtstehenden Position des Behältnisses, d. h. mit dem Mündungsbereich nach oben, von oben nach unten den Mündungsbereich, den Schulterbereich, den Grundkörper und den Bodenbereich aufweist. Unter einer aufrechtstehenden Position des Behältnisses wird dabei verstanden, dass der Mündungsbereich weiter vom Erdmittelpunkt entfernt ist, als der Bodenbereich.

Bei einer weiteren bevorzugten Ausführungsform ist das faserbasierte Material aus einer Gruppe von Materialien ausgewählt, welche Pulpe-Material (Pappmaschee), Zellstoff, Papiermasse oder dergleichen enthält.

Besonders bevorzugt sind dabei zumindest der Grundkörper, der Schulterbereich und der Bodenbereich des Behältnisses aus einem faserbasierten Material hergestellt. Bei dieser Ausführungsform des Behältnisses ist demnach der Grundkörper, der Schulterbereich und der Bodenbereich des Behältnisses getrennt von dem Mündungsbereich recyclebar. Besonders bevorzugt ist demnach in dieser Ausführungsform des Behältnisses lediglich der Mündungsbereich aus einem Kunststoffmaterial wie PET, PP, PS, PE oder dergleichen hergestellt. Denkbar wäre vorteilhaft allerdings auch das gesamte Behältnis, also den Mündungsbereich, den Schulterbereich, den Grundkörper und den Bodenbereich des Behältnisses, aus einem faserbasierten Material herzustellen.

Bei dem erfindungsgemäßen Behältnis handelt es sich demnach um ein Behältnis, welches möglichst wenig Kunststoffanteile aufweist und besonders bevorzugt vollständig auf Kunststoffanteile verzichtet.

Weitere Vorteile und Ausführungsformen ergeben sich aus der beigefügten Zeichnung.

Darin zeigt:

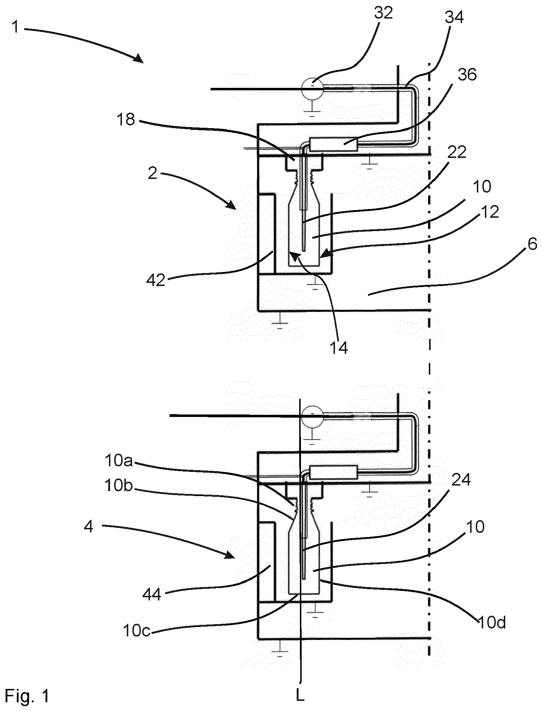

- Fig. 1: einen Ausschnitt aus einer erfindungsgemäßen Vorrichtung zum Beschichten von Behältnissen.

Figur 1 zeigt einen Ausschnitt aus einer erfindungsgemäßen Vorrichtung 1 zum Beschichten von Behältnissen 10. Die Vorrichtung 1 weist dabei in dieser Darstellung eine erste Beschichtungsstation 2 und eine zweite Beschichtungsstation 4 auf, wobei bevorzugt eine Vielzahl derartiger Beschichtungsstationen vorgesehen ist.

Die in dieser Ausführungsform gezeigten Beschichtungsstationen 2, 4 weisen jeweils eine erste Elektrode 22 bzw. 24 auf, die in ein zu beschichtendes Behältnis 10 einführbar ist. Wie oben bereits erwähnt, ist jedoch auch ein Beschichtungsverfahren denkbar, bei welchem die Energiezufuhr mittels elektromagnetischer Strahlung, wie Mikrowellenstrahlung, Hochfrequenz oder Niederfrequenz erfolgt. Weiterhin ist auch eine (nicht gezeigte) Antriebseinrichtung vorgesehen, welche eine Bewegung der ersten Elektrode 22 bzw. 24 in das Behältnis und/oder eine Bewegung des Behältnisses 10 zu der Elektrode 22 bewirkt. Die Elektrode 22 bzw. 24 wird dabei in eine Mündung bzw. einen Mündungsbereich 10a des Behältnisses eingeführt. Die erste Elektrode 22 bzw. 24 ist dabei als stangenartiger Körper ausgeführt und insbesondere als Körper, der einen Querschnitt aufweist, der geringer ist als der Mündungsquerschnitt des Behältnisses 10. Die erste Elektrode 22 der ersten Beschichtungsstation 2 und die erste Elektrode 24 der zweiten Beschichtungsstation 4 werden dabei bevorzugt unabhängig voneinander betrieben.

Daneben weisen die Beschichtungsstationen 2, 4 jeweils eine zweite Elektrode 42 bzw. 44 auf, welche außerhalb des Behältnisses 10 angeordnet ist. Bei dieser zweiten Elektrode 42 bzw. 44 handelt es sich um eine Gegenelektrode, welche hier bevorzugt geerdet ist. Die ersten Elektroden 22 bzw. 24 und die zweiten Elektroden 42 bzw. 44 sind dabei bevorzugt Bestandteil eines Beschichtungsverfahrens zur Beschichtung einer Innenwandung 14 des Behältnisses.

Das Bezugszeichen 32 kennzeichnet ein Medienreservoir, etwa ein Reservoir für den fließfähigen Presurcor bzw. das siliziumhaltige Gas. Das Bezugszeichen 34 kennzeichnet eine Zuführleitung, um den Behältnissen 10 das fließfähige Medium aus dem Medienreservoir 32 zuzuführen, und das Bezugszeichen 36 eine Steuerungseinrichtung, welche die Zuführung des Mediums in die Behältnisse 10 steuert. Insbesondere wird dabei die Zeit bzw. die Menge des fließfähigen Mediums gesteuert.

Das Behältnis 10 weist dabei wie in Figur 1 gezeigt entlang seiner Längsrichtung L aufeinanderfolgend einen Mündungsbereich 10a, einen Schulterbereich 10b, einen Bodenbereich 10c und einen Grundkörper 10d auf. Das Bezugszeichen 12 kennzeichnet weiter die Außenwandung des Behältnisses.

Das Bezugszeichen 18 kennzeichnet weiterhin eine Dichtungseinrichtung. Das Behältnis 10 wird dabei gegen diese Dichtungseinrichtung 18 gedrückt, so dass innerhalb des Behältnisses 10 ein Vakuum erzeugt werden kann.

Die Anmelderin behält sich vor, sämtliche in den Anmeldungsunterlagen offenbarten Merkmale als erfindungswesentlich zu beanspruchen, sofern sie einzeln oder in Kombination gegenüber dem Stand der Technik neu sind. Es wird weiterhin darauf hingewiesen, dass in den einzelnen Figuren auch Merkmale beschrieben wurden, welche für sich genommen vorteilhaft sein können. Der Fachmann erkennt unmittelbar, dass ein bestimmtes in einer Figur beschriebenes Merkmal auch ohne die Übernahme weiterer Merkmale aus dieser Figur vorteilhaft sein kann. Ferner erkennt der Fachmann, dass sich auch Vorteile durch eine Kombination mehrerer in einzelnen oder in unterschiedlichen Figuren gezeigter Merkmale ergeben können.

### Bezugszeichenliste

- 1: Vorrichtung
- 2: erste Beschichtungsstation
- 4: zweite Beschichtungsstation
- 6: Beschichtungskammer
- 10: Behältnis
- 10a: Mündungsbereich
- 10b: Schulterbereich
- 10c: Bodenbereich
- 10d: Grundkörper
- 12: Außenwandung des Behältnisses 10
- 14: Innenwandung des Behältnisses 10
- 18: Dichtungseinrichtung
- 22,24: erste Elektrode
- 32: Medienreservoir
- 34: Zuführleitung
- 36: Steuerungseinrichtung
- 42, 44: zweite Elektrode

## Patentansprüche

1. Verfahren zum Beschichten von Behältnissen (10), und insbesondere Getränkebehältnissen, welche dazu geeignet und bestimmt sind eine Flüssigkeit aufzunehmen, wobei das zu beschichtende Behältnis (10) einen Grundkörper (10d), einen Schulterbereich (10b), einen Bodenbereich (10c) und einen Mündungsbereich (10a) aufweist, wobei zum Beschichten einer Innenwandung (14) und/oder einer Außenwandung (12) des Behältnisses (10) aus einem fließfähigen Precursor ein siliziumhaltiges Beschichtungsmaterial erzeugt wird, welches auf die Innenwandung (14) und/oder die Außenwandung (12) des Behältnisses (10) aufgebracht wird,
**dadurch gekennzeichnet, dass**
es sich bei dem zu beschichtenden Behältnis (10) um ein Behältnis aus einem faserbasierten Material handelt.

2. Verfahren nach Anspruch 1,
**dadurch gekennzeichnet, dass**
das Behältnis (10) während der Beschichtung in einer Beschichtungskammer (6) angeordnet ist.

3. Verfahren nach wenigstens einem der vorhergehenden Ansprüche,
**dadurch gekennzeichnet, dass**
es sich bei dem siliziumhaltigen Beschichtungsmaterial um SiOx handelt.

4. Verfahren nach Anspruch 1,
**dadurch gekennzeichnet, dass**
zur Beschichtung der Innenwandung (14) des Behältnisses (10) der fließfähige Precursor verdampft wird und zusammen mit einem gasförmigen Medium und insbesondere mit einem sauerstoffhaltigen Gas in das Innere des Behältnisses eingeleitet wird.

5. Verfahren nach Anspruch 1,
**dadurch gekennzeichnet, dass**
zur Beschichtung der Außenwandung (12) des Behältnisses (10) der fließfähige Precursor unter thermischer Einwirkung auf die Außenwandung (12) des Behältnisses (10) aufgebracht wird.

6. Verfahren nach wenigstens einem der vorhergehenden Ansprüche,
**dadurch gekennzeichnet, dass**
der fließfähige Precursor aus einer Gruppe von Precursoren ausgewählt ist, welche HMDSO, HMDSN, TEOS oder andere Si-haltige Verbindungen und dergleichen enthält.

7. Verfahren nach wenigstens einem der vorhergehenden Ansprüche,
**dadurch gekennzeichnet, dass**
die Beschichtung der Innenwandung (14) und der Außenwandung (12) des Behältnisses (10) wenigstens zeitweise gleichzeitig durchgeführt wird.

8. Verfahren nach wenigstens einem der vorhergehenden Ansprüche,
**dadurch gekennzeichnet, dass**
zumindest der Grundkörper (10d), der Schulterbereich (10b) und der Bodenbereich (10c) des Behältnisses (10) aus einem faserbasierten Material hergestellt ist.

9. Verfahren nach wenigstens einem der vorhergehenden Ansprüche,
**dadurch gekennzeichnet, dass**
wenigstens der Mündungsbereich (10a) des Behältnisses (10) aus einem Kunststoffmaterial, wie PET, PP, PS, PE oder dergleichen hergestellt ist.

10. Verfahren nach wenigstens einem der vorhergehenden Ansprüche,
**dadurch gekennzeichnet, dass**
das Behältnis (10) weiterhin einen Verschluss aufweist, wobei der Verschluss aus einem Kunststoffmaterial wie PET, PP, PS, PE oder dergleichen oder einem Metall, wie Aluminium oder dergleichen hergestellt ist.

11. Vorrichtung (1) zum Beschichten von Behältnissen (10), und insbesondere Getränkebehältnissen, welche dazu geeignet und bestimmt sind eine Flüssigkeit aufzunehmen, wobei das zu beschichtende Behältnis (10) einen Grundkörper (10d), einen Schulterbereich (10b), einen Bodenbereich (10c) und einen Mündungsbereich (10a) aufweist, und die Vorrichtung (1) eine Vielzahl von Beschichtungsstationen (2, 4) aufweist, wobei die Behältnisse (10) mittels einer Transporteinrichtung zu den Beschichtungsstationen (2, 4) transportierbar sind, wobei innerhalb der Beschichtungsstation (2, 4) ein siliziumhaltiges Beschichtungsmaterial auf die Innenwandung (14) und/oder die Außenwandung (12) des Behältnisses (10) aufbringbar ist,
**dadurch gekennzeichnet, dass**
es sich bei dem zu beschichtenden Behältnis (10) um ein Behältnis aus einem faserbasierten Material handelt.

12. Behältnis (10) zur Aufnahme einer Flüssigkeit, wie insbesondere einem Getränk, wobei das Behältnis (10) entlang seiner Längsrichtung (L) aufeinanderfolgend einen Mündungsbereich (10a), einen Schulterbereich (10b), einen Grundkörper (10d) und einen Bodenbereich (10c) aufweist, wobei zumindest der Grundkörper (10d) und der Bodenbereich (10c) des Behältnisses (10) aus einem faserbasierten Material hergestellt ist,
**dadurch gekennzeichnet, dass**
das Behältnis an einer Innenwandung (14) und/oder einer Außenwandung (12) eine Beschichtung aus einem siliziumhaltigen Beschichtungsmaterial aufweist.

13. Behältnis (10) nach wenigstens einem der vorhergehenden Ansprüche,
**dadurch gekennzeichnet, dass**
das faserbasierte Material aus einer Gruppe von Materialien ausgewählt ist, welche Pulpe-Material (Pappmaschee), Zellstoff, Papiermasse oder dergleichen enthält.

14. Behältnis (10) nach wenigstens einem der vorhergehenden Ansprüche,
**dadurch gekennzeichnet, dass**
zumindest der Grundkörper (10d), der Schulterbereich (10b) und der Bodenbereich (10c) des Behältnisses (10) aus einem faserbasierten Material hergestellt ist.
